# FASCICULE DE BREVET EUROPEEN

(11) **EP 4 572 593 B1**
(45) Date de publication et mention de la délivrance du brevet: **29.04.2026**
(21) Numéro de dépôt: 24217951.3
(22) Date de dépôt: 06.12.2024
(51) Int. Cl.: H10N 70/20, H10B 63/00

(54) **PROCÉDÉ DE FABRICATION D'UN DISPOSITIF MÉMOIRE ET UN DISPOSITIF MÉMOIRE**
VERFAHREN ZUR HERSTELLUNG EINER SPEICHERVORRICHTUNG UND EINE SPEICHERVORRICHTUNG
METHOD FOR MANUFACTURING A MEMORY DEVICE AND A MEMORY DEVICE

(30) Priorité: 13.12.2023 FR 2314090
(43) Date de publication de la demande: 18.06.2025
(73) Titulaire: Commissariat à l'Energie Atomique et aux Energies Alternatives, 75015 Paris (FR)
(72) Inventeur: PARES, Gabriel, 38054 Grenoble Cedex 09 (FR)
(74) Mandataire: Hautier IP

(56) Documents cités:
- US-A1- 2009 046 498
- US-A1- 2009 269 928
- US-A1- 2010 084 741

## Description

### DOMAINE TECHNIQUE

La présente invention concerne les mémoires résistives non volatiles intégrées dans un réseau d'interconnexion, par exemple d'une technologie de type CMOS (de l'anglais « Complementary Metal Oxide Semiconductor », en français « semi-conducteur à oxyde métallique complémentaire »). Elle peut s'appliquer à différents types de mémoires résistives et notamment aux mémoires résistives à base d'oxyde (OxRAM), aux mémoires résistives à base d'un ferro-électrique (FeRAM), aux mémoires résistives à pont conducteur (CBRAM).

### ETAT DE LA TECHNIQUE

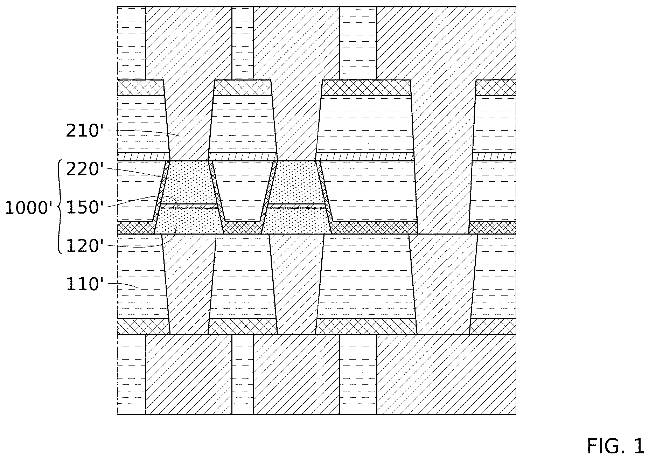

Comme illustré à la figure 1, les points mémoires 1000' de mémoires résistives non volatiles sont classiquement constitués de trois éléments empilés : une électrode conductrice inférieure 120', une couche active 150' dont les propriétés permettent un changement d'état afin de stocker une information, et une électrode conductrice supérieure 220'.

Dans le cas d'une mémoire résistive de type OxRAM, la couche active est à base d'un diélectrique. L'application d'un champ électrique aux bornes des électrodes inférieure et supérieure permet de rompre ou de former un filament conducteur au sein de la couche diélectrique et ainsi de passer d'un état de haute résistivité à un état de basse résistivité de la couche diélectrique, ces deux états correspondant respectivement à l'information « 0 » (ou état « OFF ») et à l'information « 1 » (ou état « ON ») de la mémoire.

L'intégration d'un tel point mémoire dans un réseau d'interconnexion est communément basée sur une structure de type « mésa » dans laquelle le point mémoire est formé selon un motif réalisé par lithographie. Les connexions aux électrodes sont communément réalisées par des vias 110', 210' reliés à des lignes de métal constituant le réseau d'interconnexion. Par ailleurs, la structure mésa ainsi réalisée est ensuite encapsulée par un empilement de couches diélectriques puis planarisée afin d'être isolée électriquement et de pouvoir réaliser des niveaux d'interconnexion supérieurs. Ce réseau d'interconnexion fait de préférence partie des couches qualifiées de BEOL, acronyme du vocable anglais « Back End Of Line », que l'on peut traduire par « fin de ligne » en français.

Afin d'augmenter la densité de points mémoires dans chacun des plans mémoire, on cherche à réduire les dimensions des points mémoires et/ou à diminuer leur espacement. Un des écueils majeurs se dressant sur cette voie est la dimension minimum accessible pour réaliser une structure de type mésa. Notamment, la taille du point mémoire est actuellement déterminée par la taille du motif de lithogravure. Or, les techniques de lithogravure les plus avancées utilisant la lithographie en immersion en extrême ultraviolet (EUV) et les gravures par plasma de type DRIE (pour Dry Reactive Ion Etching en anglais, signifiant gravure ionique réactive sèche) présentent au mieux une résolution d'environ 60 nm pour définir des structures de type « mésa » c'est-à-dire des points isolés. Les densités de points mémoires ainsi obtenues ne sont pas satisfaisantes et il existe un besoin de surpassement de cette barrière dimensionnelle afin de pouvoir réaliser des dispositifs mémoires plus performants et/ou présentant des dimensions globales plus petites.

Des exemples de l'art anterieur se trouvent dans les documents US2010/084741 A1 et US2009/269928 A1.

Un objectif de la présente invention est donc de proposer une solution pour l'amélioration de la densité de points mémoires au sein de dispositifs mémoire.

### RESUME

Pour atteindre cet objectif, un premier objet de l'invention concerne un dispositif mémoire comprenant une pluralité de points mémoires, le dispositif comprenant une pluralité de premières électrodes et une pluralité de deuxièmes électrodes, chaque deuxième électrode se trouvant au moins en partie en regard d'une première électrode, caractérisé en ce qu'il comprend en outre une couche active s'étendant de manière continue entre la pluralité de première électrodes et la pluralité de deuxièmes électrodes, et en ce que :
- chaque première électrode,
- une deuxième électrode se trouvant au moins en partie en regard de ladite première électrode, et
- une portion de couche active s'étendant entre ladite première électrode et ladite deuxième électrode
forment ensemble un point mémoire.

Un deuxième objet de l'invention concerne un procédé de fabrication d'un dispositif mémoire comprenant une pluralité de points mémoires, le procédé comprenant les étapes suivantes :
- Former une pluralité de premières électrodes,
- Former une couche active sur chacune des premières électrodes, la couche active étant continue,
Former une pluralité de deuxièmes électrodes sur la couche active, chaque deuxième électrode se trouvant au moins en partie en regard d'une première électrode, chaque première électrode, une deuxième électrode se trouvant au moins en partie en regard de ladite première électrode, et une portion de couche active s'étendant entre ladite première électrode et ladite deuxième électrode formant ensemble un point mémoire.

La couche active étant commune à la pluralité de points mémoires, les points mémoires ainsi formés ne requièrent pas d'étapes de lithographie et de gravure pour former la couche active, étapes technologiques dont la résolution est actuellement limitée à 60 nm. Les techniques existantes permettent en revanche de former des électrodes avec des étapes de lithographie et de gravure ayant une résolution allant en deça de 40 nm. Ainsi, le procédé selon l'invention peut permettre d'augmenter fortement, typiquement doubler, la densité de points mémoires au sein d'un dispositif mémoire.

Par ailleurs, le fait de se passer de gravure pour la formation du motif du point mémoire permet de limiter les défauts en bord de motif dus à cette étape de fabrication. Ces défauts, très peu maîtrisés dans l'art antérieur, peuvent mener à une détérioration des performances du dispositif mémoire. Le procédé selon l'invention permet donc de réaliser un dispositif mémoire aux performances améliorées par rapport à l'art antérieur.

Le fait que la couche active soit continue et commune à plusieurs points mémoires permet de se passer d'étapes de lithographie et gravure pouvant endommager la couche active et finalement conduire à de moins bonnes performances du dispositif mémoire. Dans le cadre du développement de la présente invention, il a été observé que cette mutualisation de la couche active n'entrave pas le bon fonctionnement de chacun des points mémoires.

Par ailleurs, le dispositif selon l'invention comprend un empilement comprenant, empilés selon une direction dite d'empilement, dans cet ordre :
- Une première couche support présentant une face supérieure, la première couche support comprenant une pluralité de premiers trous s'étendant chacun depuis sa face supérieure, chaque premier trou logeant :
   i. Un premier via métallique,
   ii. Une première électrode de la pluralité de premières électrodes, chaque première électrode surmontant un premier via métallique distinct,
- La couche active, surmontant la face supérieure de la première couche support,
- sur la couche active, une deuxième couche support comprenant une pluralité de deuxièmes trous la traversant et débouchant chacun sur la couche active, chaque deuxième trou logeant :
   i. un deuxième via métallique,
   ii. une deuxième électrode de la pluralité de deuxième électrodes, ladite deuxième électrode étant disposée entre le deuxième via métallique et la couche active, et se trouvant au moins en partie en regard d'une première électrode parmi la pluralité de premières électrodes.

Similairement, dans le procédé selon l'invention, l'étape de formation de la pluralité de premières électrodes comprend les étapes suivantes :
- Fournir une première couche support, présentant une face supérieure et une face inférieure opposées l'une à l'autre, la première couche support comprenant une pluralité de premiers trous s'étendant chacun depuis sa face supérieure et débouchant sur sa face inférieure,
- Former une première électrode dans chaque premier trou de la pluralité de premiers trous,
la couche active étant formée sur la face supérieure de la première couche support,
le procédé comprenant en outre une étape de formation dans chaque premier trou d'un premier via métallique, la première électrode se trouvant au contact du premier via métallique.

Le procédé comprend en outre les étapes suivantes :
- Former une deuxième couche support sur la couche active, la deuxième couche support comprenant une pluralité de deuxièmes trous traversant la deuxième couche support et débouchant chacun sur la couche active, chaque deuxième trou se trouvant au moins en partie en regard d'une première électrode différente,
- Former dans chaque deuxième trou de la pluralité de deuxièmes trous une deuxième électrode de la pluralité de deuxièmes électrodes et un deuxième via métallique, la deuxième électrode se trouvant au contact du deuxième via métallique.

Les points mémoires ainsi formés ne requièrent ainsi que la formation de trous dans la première couche support et dans la deuxième couche support. Les techniques existantes permettent de former des trous tels que ceux formés dans ce mode de réalisation avantageux du procédé selon l'invention avec une résolution allant en deçà de 40 nm.

Les premiers trous et les deuxièmes trous présentent par ailleurs de préférence chacun un profil continu le long de la direction d'empilement.

Les avantages présentés en référence au procédé selon le deuxième aspect de l'invention s'appliquent mutatis mutandis au dispositif selon le premier aspect de l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente des points mémoires selon l'art antérieur au sein d'un réseau d'interconnexion.
Les figures 2A à 2M illustrent un mode de réalisation du procédé selon l'invention.
La figure 3 illustre un mode de réalisation dans lequel deux points mémoires partagent une électrode et un via.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions et épaisseurs relatives ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation préféré, les premiers trous présentent chacun un profil continu le long de la direction d'empilement en projection dans tout plan comprenant la direction d'empilement. Selon un mode de réalisation préféré, les deuxièmes trous présentent chacun un profil continu le long de la direction d'empilement en projection dans tout plan comprenant la direction d'empilement.

Selon un exemple, chaque deuxième électrode est en contact direct avec la couche active.

Selon un mode de réalisation, au moins une première électrode parmi la pluralité de premières électrodes se trouve au moins en partie en regard d'au moins deux deuxièmes électrodes.

Selon un mode de réalisation alternatif, chacune des premières électrodes se trouve en regard d'une unique deuxième électrode.

Selon un exemple, le premier via métallique et la première électrode contenus dans un même premier trou sont à base de matériaux distincts. Selon un exemple, le deuxième via métallique et la deuxième électrode contenus dans un même premier trou sont à base de matériaux distincts.

Selon un exemple, le premier via métallique est à base de l'un parmi les matériaux suivants : W, WN, Ru, Co, Ni, Cu, une combinaison de couches comportant ces matériaux ou un alliage de ces matériaux. Selon un exemple, le deuxième via métallique est à base de l'un parmi les matériaux suivants : W, WN, Ru, Co, Ni, Cu, une combinaison de couches comportant ces matériaux ou un alliage de ces matériaux.

Selon un exemple, la première électrode est à base de l'un parmi les matériaux suivants : TiN, Ti, TaN, W, WN, Ru, C, Si, Co, Ni, une combinaison de couches comportant ces matériaux ou un alliage de ces matériaux. Selon un exemple, la deuxième électrode est à base de l'un parmi les matériaux suivants : TiN, Ti, TaN, W, WN, Ru, C, Si, Co, Ni, une combinaison de couches comportant ces matériaux ou un alliage de ces matériaux.

Selon un exemple, le dispositif comprend en outre une couche de protection entre la couche active et la deuxième couche support.

Selon un exemple, la couche active est à base d'un diélectrique, par exemple l'un parmi les matériaux suivants :
- SiOₓ avec x égal à 1 ou 2, tel que SiO₂,
- HfOₓ avec x égal à 1 ou 2, tel que HfO₂,
- Al₂O₃,
- TiO₂,
- Ta₂O₅,
- ZrO₂,
- un alliage de ces éléments.

Selon un exemple, la couche active est à base d'un matériau ferroélectrique, par exemple l'un parmi du HfₓZr₁₋ₓO₂ avec 0<x<1, du HfO₂ dopé Si, de l'AIScN et un titano-zirconate de plomb (PZT). Dans le cas d'une couche active à base de HfO₂ dopé Si, le Si est de préférence présent dans une concentration inférieure ou égale à 10% atomique, de préférence sensiblement égale à 1% atomique.

Selon un exemple, la couche active comprend un électrolyte solide par exemple à base de l'un parmi : du sulfure de germanium dopé d'argent et du sulfure de germanium dopé de cuivre.

Selon un exemple avantageux, chaque première électrode affleure la face supérieure de la première couche support.

Selon un mode de réalisation, le dispositif comprend en outre une pluralité de premières électrodes secondaires et une pluralité de deuxièmes électrodes secondaires, chaque deuxième électrode secondaire se trouvant au moins en partie en regard d'une première électrode secondaire, le dispositif comprenant en outre une couche active secondaire s'étendant de manière continue entre la pluralité de première électrodes secondaires et la pluralité de deuxièmes électrodes secondaires, et :
- chaque première électrode secondaire,
- une deuxième électrode secondaire se trouvant au moins en partie en regard de ladite première électrode secondaire, et
- une portion de couche active secondaire s'étendant entre ladite première électrode secondaire et ladite deuxième électrode secondaire forment ensemble un point mémoire secondaire.

Selon un exemple préféré, chaque point mémoire est une mémoire résistive à base d'oxyde (OxRam).

On entend que deux éléments sont isolés l'un de l'autre s'ils ne sont pas en contact direct et sont séparés l'un de l'autre par un milieu ou un matériau présentant une résistivité électrique supérieure à 10⁶ Ω.m.

Selon un mode de réalisation avantageux, la première couche support comprend au moins un premier trou contact, la deuxième couche support comprend au moins un deuxième trou contact, le premier trou contact et le deuxième trou contact étant au moins en partie en regard l'un de l'autre, le procédé comprenant en outre les étapes suivantes :
- Former dans le premier trou contact un premier via métallique contact,
- Former dans le deuxième trou contact un deuxième via métallique contact, le premier via métallique contact et le deuxième via métallique contact étant en conduction électrique.

On entend que deux éléments sont en conduction électrique lorsqu'ils sont en contact direct ou bien en contact par l'intermédiaire de couches dites conductrices présentant typiquement une résistivité inférieure à 150 µΩ.cm. Le premier via métallique contact et le deuxième via métallique contact sont de préférence en contact direct. Selon une variante, le premier via métallique contact et le deuxième via métallique contact sont en contact par l'intermédiaire d'au moins une couche métallique, typiquement une première électrode contact et/ou une deuxième électrode contact.

Selon un exemple, le premier via métallique et la première électrode se trouvant dans un même premier trou sont formés lors d'une même étape de dépôt.

Selon un exemple avantageux, la formation de la deuxième couche support comprend une étape de dépôt de la couche support et une étape de formation dans la couche support de la pluralité de premiers trous, le procédé comprenant en outre, après la formation de la deuxième couche support sur la couche active, et avant la formation dans chaque deuxième trou du deuxième via métallique et de la deuxième électrode, une étape de traitement de la couche active au travers des deuxièmes trous, l'étape de traitement de la couche active ayant de préférence lieu à l'un parmi les temps suivants:
- Avant la formation de la deuxième couche support,
- Après le dépôt de la deuxième couche support et avant la formation de la pluralité de premiers trous,
- Après la formation de la pluralité de premiers trous.

Selon un exemple, le procédé comprend en outre, après la formation de la couche active, et avant la formation de la deuxième couche support, la formation d'une couche de protection sur une face supérieure de la couche active.

Selon un exemple, le procédé comprend en outre, après la formation de la deuxième couche support sur la couche active, un retrait de portions de la couche de protection apparentes au travers des deuxièmes trous.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

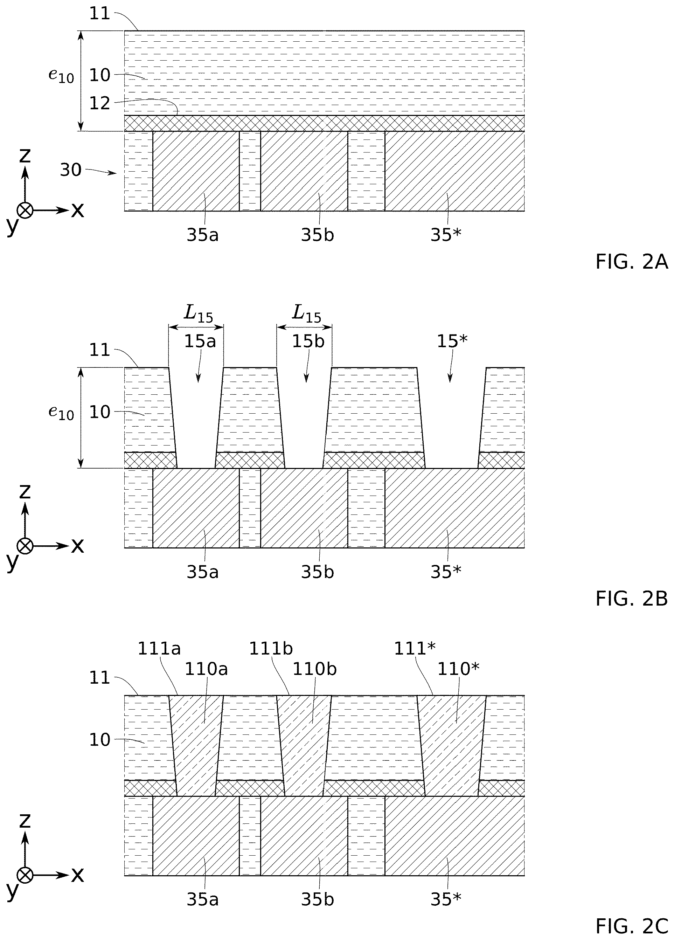

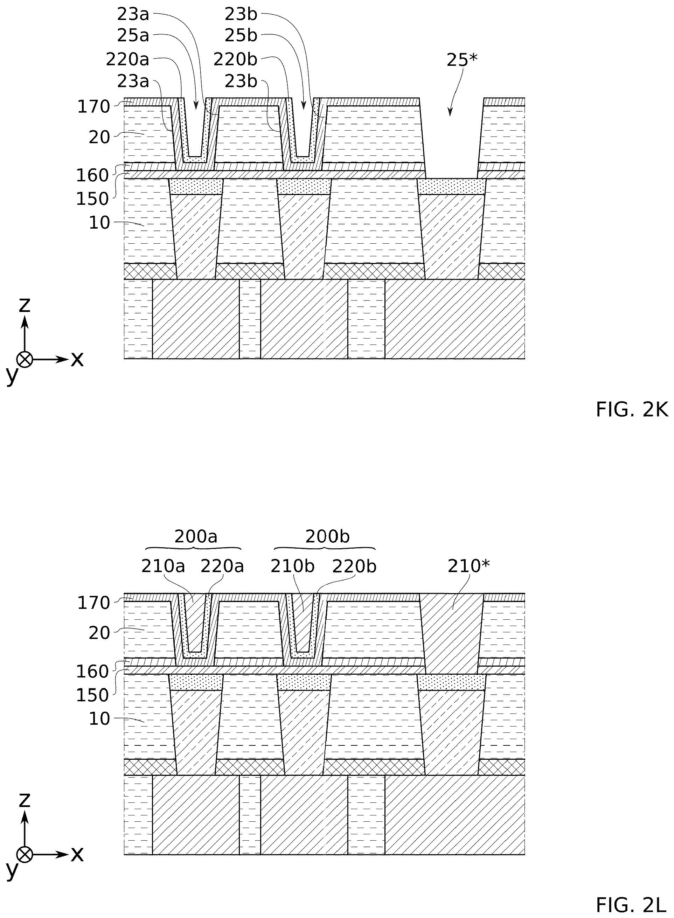

Un repère, de préférence orthonormé, comprenant les axes X, Y, Z est représenté en figures 2A à 2K. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan horizontal XY. L'épaisseur est prise selon une direction normale au plan d'extension principal de la couche. Ainsi, une couche présente typiquement une épaisseur selon Z, lorsqu'elle s'étend principalement le long du plan horizontal XY, et un élément en saillie, par exemple une tranchée d'isolation, présente une hauteur selon Z. Les termes relatifs « sur », « sous », « sous-jacent » se réfèrent préférentiellement à des positions prises selon la direction Z.

Les termes « sensiblement », « environ », « de l'ordre de » signifient « à 10% près, de préférence à 5% près ».

Un mode de réalisation du procédé selon l'invention va maintenant être décrit en référence aux figures 2A à 2K. Pour des raisons de clarté, ces figures illustrent l'obtention de deux points mémoires uniquement. Naturellement, ces étapes peuvent permettre d'obtenir simultanément de nombreux points mémoires à partir d'une même première couche support, d'une même couche active et d'une même deuxième couche support.

La figure 2A illustre la fourniture d'un empilement comprenant notamment une première couche support 10. Cette première couche support 10 peut reposer, comme cela est illustré, sur tout support 30 adéquat pour les applications envisagées. Il s'agit typiquement d'une ligne comprenant des éléments de connexion métallique 35a, 35b, du type « fin de ligne » ou « BEOL ». Ce support 30 peut être qualifiée de ligne métallique inférieure ou encore de ligne d'interconnexion inférieure. Le support 30 peut également comprendre d'autres niveaux métalliques. Le support 30 peut en outre comprendre des transistors.

La première couche support 10 présente une face inférieure 12 en regard de ce support 30, ainsi qu'une face supérieure 11 opposée à la face inférieure 12. Comme illustré à la figure 2B, des trous dits premiers trous 15a, 15b sont ensuite formés dans la première couche support 10 à partir de sa face supérieure 11.

De préférence, les premiers trous 15a, 15b traversent la première couche support10 sur toute son épaisseur e₁₀ selon la direction Z. Avantageusement, chaque premier trou 15a, 15b débouche sur une interconnexion métallique 35a, 35b de la ligne métallique inférieure 30. Il est également envisageable que, dans un premier temps, les premiers trous 15a, 15b ne débouchent pas sur la face inférieure 12 de la première couche support 10. Il sera possible, après la formation des points mémoires 1000a, 1000b, de polir ou meuler (par exemple par polissage mécano-chimique - CMP) cette face inférieure 12 afin de faire affleurer au niveau de cette dernière les premiers vias métalliques 110a, 110b, dont la formation sera décrite plus avant. L'assemblage avec la ligne métallique inférieure 30 a alors lieu après cette étape de polissage.

Les premiers trous 15a, 15b peuvent par exemple être formés par lithographie et gravure. Il s'agit de préférence d'une gravure anisotrope telle qu'une gravure ionique réactive ou une gravure plasma.

Le profil des premiers trous 15a, 15b est de préférence continu. En particulier, le profil des premiers trous 15a, 15b est continu le long d'une direction perpendiculaire à la face supérieure 11 de la première couche support10 (ici la direction d'empilement Z). On entend par profil continu un profil ne présentant pas de changement abrupt de section dans le plan horizontal XY le long de la direction d'empilement Z. Un tel changement peut par exemple être appelé décrochage. Un tel décrochage est par exemple obtenu lorsqu'une première couche est gravée selon un certain motif, puis qu'une deuxième couche est déposée sur la première couche selon un autre motif. Dit autrement, chaque premier trou 15a, 15b définit une surface continue, cette surface correspondant à la délimitation par la première couche support 10 dudit premier trou 15a, 15b. En particulier, en projetant le profil dans tout plan perpendiculaire au plan horizontal XY, ce profil est continu le long de la direction d'empilement Z. Ainsi, en parcourant le premier trou 15a, 15b depuis la face supérieure 11 jusqu'à la face inférieure 12, l'on définit une courbe, de préférence une ligne droite. Cette courbe ne présente pas d'angle. Cette ligne droite peut être verticale ou de préférence oblique dans un plan contenant Z, comme illustré sur les figures. Avantageusement, la surface définie par chaque premier trou 15a, 15b dans la première couche support 10 présente une symétrie de révolution autour d'un axe parallèle à la direction d'empilement Z.

Le profil des premiers trous 15a, 15b peut être constant ou non le long de la direction d'empilement Z. Un trou présentant un profil constant est un trou dont la section dans le plan horizontal XY est constante sur toute la hauteur selon Z du trou. Au contraire, un trou ne présentant pas un profil constant est un trou dont la section dans le plan horizontal XY varie le long de la hauteur du trou.

Les premiers trous 15a, 15b présentent chacun, dans le plan horizontal XY, une dimension maximale L₁₅. Dans le cas typique de trous présentant, en projection dans le plan horizontal XY, une forme circulaire, leur dimension maximale correspond à leur diamètre. Si un trou ne présente pas une section constante le long de la direction d'empilement Z, alors on considère que L₁₅ correspond au diamètre (ou autre dimension caractéristique) maximal pris par ce trou le long de la direction Z. De préférence, L₁₅ est inférieure à 200 nm, de préférence inférieure à 100 nm, et de manière encore plus avantageuse inférieure à 50 nm. L₁₅ peut notamment être sensiblement égale à 40 nm.

Selon un mode de réalisation avantageux, au moins un premier trou contact 15* est également formé dans la première couche support 10 à partir de sa face supérieure 11. Le premier trou contact 15* et les premiers trous 15a, 15b sont de préférence formés simultanément, lors d'une même étape de gravure. Avantageusement, le premier trou contact 15* débouche sur une interconnexion métallique 35* de la ligne métallique inférieure 30.

On obtient ainsi la première couche support 10 comprenant une pluralité de premiers trous 15a, 15b, et de préférence au moins un premier trou contact 15*, qui, selon un mode de réalisation avantageux du procédé selon l'invention, est fournie lors de la première étape du procédé.

Comme illustré par le passage de la figure 2B à la figure 2E, une deuxième étape du procédé consiste en le remplissage de chaque premier trou 15a, 15b avec un premier via métallique 110a, 110b et une première électrode 120a, 120b.

Les caractéristiques décrites ci-dessous pour un premier via métallique 110a, 110b et une première électrode 120a, 120b s'appliquent à l'ensemble des premiers vias métalliques 110a, 110b et des premières électrodes 120a, 120b.

Le premier via métallique 110a, 110b est de préférence en contact avec une interconnexion métallique 35a, 35b de la ligne métallique inférieure 30. La première électrode 120a, 120b et le premier via métallique 110a, 110b sont en contact.

La première électrode 120a, 120b peut être multicouches.

La première électrode 120a, 120b est de préférence à base d'un matériau inerte vis-à-vis de la couche active 150, c'est-à-dire ne participant pas au mécanisme de formation et rupture du filament dans la couche active, dans un cas particulier elle peut favoriser la création d'un filament conducteur au sein de la couche active 150 qui sera décrite plus avant. Elle peut être à base du même matériau que le premier via métallique 110a, 110b, ou bien à base d'un matériau distinct.

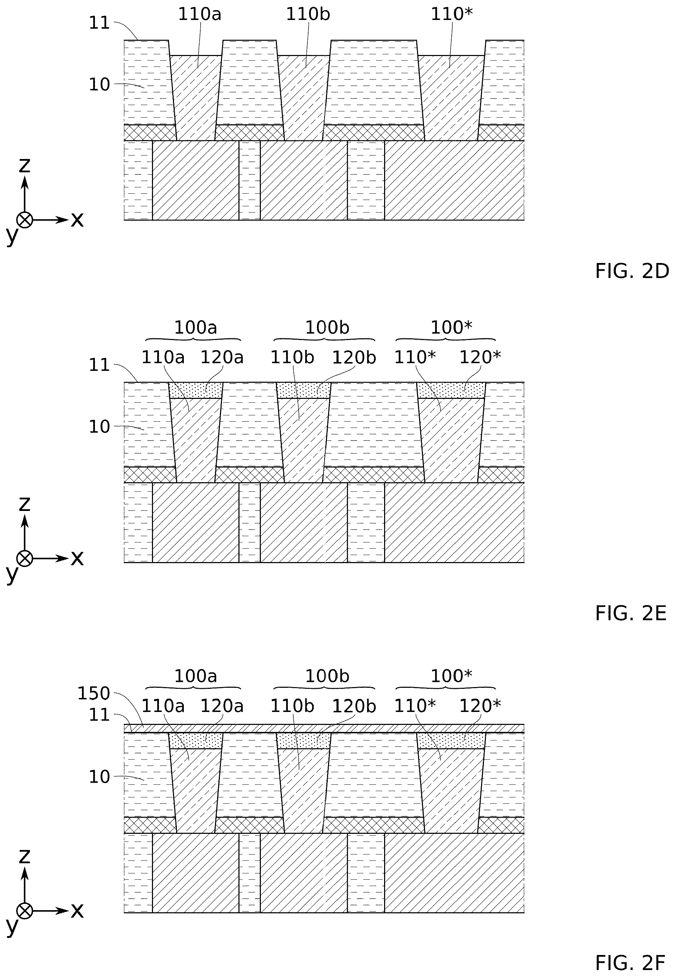

Selon un premier exemple illustré par la séquence d'étapes illustrées aux figures 2B, 2C, 2D et 2E, les premiers trous 15a, 15b sont tout d'abord intégralement remplis par le premier via métallique 110a, 110b (figure 2C), puis une portion de ce premier via métallique 110a, 110b est retiré, typiquement par gravure, depuis sa face supérieure 111a, 111b (figure 2D). L'espace ainsi laissé vide par ce retrait dans le premier trou 15a, 15b est ensuite au moins partiellement, de préférence entièrement, rempli par la première électrode 120a, 120b (figure 2E).

Selon un deuxième exemple illustré par la séquence d'étapes illustrées aux figures 2B, 2D et 2E, les premiers trous 15a, 15b sont tout d'abord partiellement remplis par le premier via métallique 110a, 110b (figure 2D), puis la première électrode 120a, 120b est déposée sur le premier via métallique 110a, 110b (figure 2E).

Dans les deux cas, l'ensemble constitué du premier via métallique 110a, 110b et de la première électrode 120a, 120b se trouvant dans un même premier trou 15a, 15b constitue un premier ensemble conducteur 100a, 100b. Tout comme les premiers trous 15a, 15b, les premiers ensemble conducteurs 100a, 100b ont un profil continu.

Comme illustré sur les figures 2C à 2E, un premier via métallique contact 110* et une première électrode contact 120* sont formés dans le premier trou contact 15*, de préférence lors des mêmes étapes de dépôt et gravure que les premiers vias métalliques 110a, 110b et que les premières électrodes 120a, 120b, respectivement. Il est entendu cependant que le premier trou contact 15* peut accueillir uniquement un premier via métallique contact 110* ou bien uniquement une première électrode contact 120*. Le premier via métallique contact 110*, la première électrode contact 120* ou bien l'ensemble des deux, selon les cas, constitue un premier ensemble conducteur contact 100*. Le premier ensemble conducteur contact 100* est de préférence en contact avec une interconnexion métallique 35* de la ligne métallique inférieure 30.

Le dépôt des premières électrodes 120a, 120b, des premiers vias métalliques 110a, 110b, du premier via métallique contact 110* et de la première électrode contact 120* peut par exemple se faire par dépôt physique en phase vapeur (PVD, « Physical Vapor Deposition ») ou encore par dépôt chimique en phase vapeur (CVD, « Chemical Vapor Deposition »).

Il est entendu qu'après la formation des premiers vias métalliques 110a, 110b, des premiers vias métalliques contact 110*, des premières électrodes 120a, 120b, et des premières électrodes contact 120* dans les premiers trous 15a, 15b et dans les premiers trous contact 15*, la première couche support 10 définit toujours ces trous 15a, 15b, 15*, même si ceux-ci sont remplis. Ainsi, dans la suite de la présente description, un trou formé dans la couche support 10 peut donc désigner un trou vide ou un trou rempli.

Comme illustré à la figure 2F, lors d'une troisième étape du procédé, une couche active 150 est formée sur la face supérieure 11 de la première couche support 10 et sur, et de préférence au contact de, chacune des premières électrodes 120a, 120b. La couche active 150 s'étend ainsi au-dessus d'une pluralité de premiers ensembles conducteurs 100a, 100b. La couche active 150 est continue, ainsi il y a continuité de matière entre les portions de la couche active 150 surplombant les différents premiers ensembles conducteurs 100a, 100b.

La couche active 150 peut être multicouche. Elle est de préférence monocouche.

Par ailleurs, à ce stade du procédé, la couche active 150 recouvre de préférence également le premier ensemble conducteur contact 100*. En effet, déposer la couche active 150 sur toute la surface de l'empilement (dépôt dit « pleine plaque ») permet de simplifier le procédé.

La couche active 150 est à base d'un matériau pouvant sélectivement passer d'un premier état présentant une première résistivité à un deuxième état présentant une deuxième résistivité, différent de la première. De préférence, la première résistivité est supérieure à 2 fois, de préférence 10 fois, et de préférence 100 fois, la deuxième résistivité.

A ce stade, il est possible de procéder à une étape de traitement de la couche active 150. Il peut s'agir d'un traitement de surface ou bien d'un traitement effectif dans toute l'épaisseur de la couche active 150. Le traitement peut par exemple être une implantation ionique visant à modifier les propriétés de la couche favorisant la formation ou la rupture du filament conducteur. Un traitement thermique peut également être réalisé à ce stade pour relaxer les contraintes dans la couche active 150 et ainsi limiter les défauts structuraux pouvant être présents après le dépôt, ou encore modifier la structure de la couche active 150 afin de favoriser la formation ou la rupture du filament conducteur. **En** particulier, ce traitement thermique peut permettre de passer d'un état amorphe de la couche active 150 à un état cristallin, ce qui peut être recherché de préférence dans le cas d'une mémoire de type FeRAM. Ce traitement peut être fait dans un four à l'échelle de la plaque.

Avantageusement, une couche de protection 160 est formée sur la couche active 150. Cette couche de protection 160 peut par exemple être à base de SiN, SiCN, carbone, ou tout autre matériau offrant une bonne sélectivité à la gravure à la fois par rapport à la deuxième couche support 20 décrite plus avant et à la couche active 150 de telle sorte qu'il sera possible de graver les deuxièmes trous 25a et 25b en s'arrêtant sur cette couche 160 et sans endommager la couche active 150, puis de retirer les portions de la couche 160 exposées dans les fonds des deuxièmes trous 25a et 25b par un procédé permettant de peu voire ne pas dégrader les premières électrodes 120a, 120b.

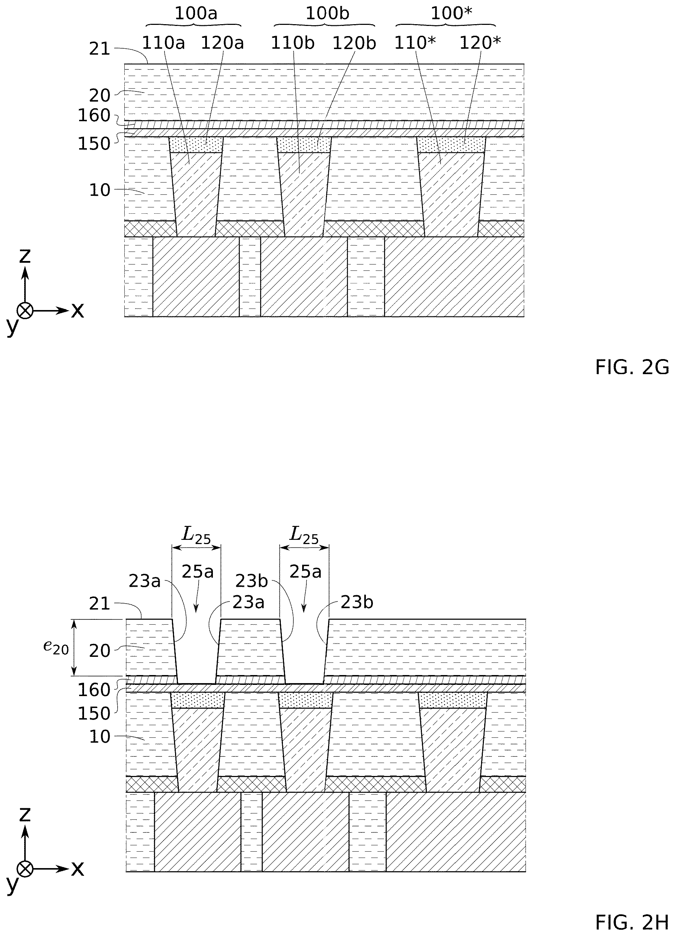

La figure 2G illustre le dépôt d'une deuxième couche support 20 sur la couche active 150. Cette deuxième couche support 20 recouvre indirectement au moins la pluralité de trous 15a, 15b, dorénavant remplis par la pluralité de premiers ensembles conducteurs 100a, 100b. Elle recouvre également avantageusement le premier ensemble conducteur contact 100*. Si une couche de protection 160 a préalablement été déposée sur la couche active 150, la deuxième couche support 20 la recouvre également, de préférence en étant à son contact.

Après la formation de la deuxième couche support 20, il est possible de réaliser une étape de traitement. Il peut notamment s'agir d'un traitement thermique tel que décrit précédemment. Lorsque ce traitement thermique est réalisé à ce stade du procédé, la deuxième couche support 20 permet de protéger la couche active 150 au cours du traitement.

Comme illustré à la figure 2H, une pluralité de deuxièmes trous 25a, 25b est ensuite formée dans la deuxième couche support 20, à partir de sa face supérieure 21. Les deuxièmes trous 25a, 25b traversent chacun la deuxième couche support 20 sur toute son épaisseur e₂₀ selon la direction Z. Chaque deuxième trou 25a, 25b débouche ainsi sur la couche active 150 et se trouve en regard d'un premier trou 15a, 15b distinct.

Si une couche de protection 160 est présente entre la couche active 150 et la deuxième couche support 20, les deuxièmes trous 25a, 25b traversent également la couche de protection 160 sur toute son épaisseur selon la direction Z. La formation des deuxièmes trous 25a, 25b peut alors se faire en deux étapes : une première gravure dans la deuxième couche support 20 et une deuxième gravure dans la couche de protection 160. La couche de protection 160 protège alors la couche active 150 lors de la gravure des deuxièmes trous 25a, 25b dans la deuxième couche support 20. Elle est elle-même avantageusement retirée localement grâce à un procédé endommageant très peu voire n'endommageant pas la couche active 150, par exemple une gravure chimique ou par RIE (de l'anglais « Reactive Ion Etching », signifiant gravure ionique réactive) sélectivement à la couche active. La présence de la couche de protection 160 et la formation des deuxièmes trous 25a, 25b en deux étapes de retrait successives et distinctes permettent ainsi de limiter la dégradation de la couche active 150. Cela permet d'optimiser les performances des points mémoires obtenus en fin de procédé.

Comme pour les premiers trous 15a, 15b, le profil des deuxièmes trous 25a, 25b est continu et peut être constant ou non le long de la direction d'empilement Z.

Les deuxièmes trous 25a, 25b présentent chacun, dans le plan horizontal XY, une dimension maximale L₂₅. Dans le cas typique de trous présentant, en projection dans le plan horizontal XY, une forme circulaire, leur dimension maximale correspond à leur diamètre. Si un trou ne présente pas une section constante le long de la direction d'empilement Z, alors on considère que L₁₅ correspond au diamètre (ou autre dimension caractéristique) maximal pris par ce trou le long de la direction Z. De préférence, L₂₅ est inférieure à 200 nm, de préférence inférieure à 100 nm, et de manière encore plus avantageuse inférieure à 50 nm. L₂₅ peut notamment être sensiblement égale à 40 nm. Il est à noter que les deuxièmes trous 25a, 25b peuvent présenter une dimension maximale L₂₅ différente de la dimension maximale L₁₅ des premiers trous.

A ce stade, il est possible de procéder à une étape de traitement de la couche active 150 au travers des deuxièmes trous 25a, 25b. Plus exactement, le traitement est effectif au niveau des portions de la couche active 150 apparentes au travers des deuxièmes trous 25a, 25b. Il peut s'agir d'un traitement de surface ou bien d'un traitement effectif dans toute l'épaisseur de la couche active 150. Le traitement peut par exemple être une implantation ionique visant à modifier les propriétés de la couche favorisant la formation ou la rupture du filament conducteur. Un traitement thermique peut également être réalisé à ce stade pour relaxer les contraintes dans la couche active 150 et ainsi limiter les défauts structuraux pouvant être présents après le dépôt ou bien après la gravure des trous 25a, 25b, ou encore modifier la structure de la couche active 150 afin de favoriser la formation ou la rupture du filament conducteur. En particulier, ce traitement thermique peut permettre de passer d'un état amorphe de la couche active 150 à un état cristallin, ce qui peut être recherché de préférence dans le cas d'une mémoire de type FeRAM. Ce traitement peut être fait dans un four à l'échelle de la plaque ou en utilisant un LASER localement au niveau des deuxièmes trous 25a, 25b.

A ce stade il est également possible de déposer une deuxième couche active 170 sur toute la surface exposée de l'empilement, à savoir sur la face supérieure 21 et les flancs internes 23a, 23b de la couche support 20 et sur les portions de la couche active 150 apparentes au travers des deuxièmes trous 25a, 25b. Cette deuxième couche active 170 peut avantageusement améliorer les performances du point mémoire en association avec la première couche active 150. Cette couche 170 est déposée de façon continue sur l'ensemble de la plaque sans nécessité d'être gravée (à l'exception d'une portion qui sera gravée lors de la formation du deuxième trou contact 25* décrit ci-dessous).

Selon un mode de réalisation avantageux, au moins un deuxième trou contact 25* est également formé dans la deuxième couche support 20 à partir de sa face supérieure 11, et, si elles ont été préalablement déposées, dans la couche de protection 160 et dans la deuxième couche active 170. De même, si la couche active 150 a préalablement été déposée jusque sur le premier ensemble conducteur 100*, le deuxième trou contact 25* traverse également la couche active 150.

Le deuxième trou contact 25* est formé de façon indépendante des deuxièmes trous 25a, 25b afin de graver la couche active 150 et éventuellement la couche de protection 160 uniquement dans ce deuxième trou contact 25* les zones de la couche active 150 ou de la couche de protection 160 apparentes au travers des deuxièmes trous 25a, 25b étant alors protégées.

Selon un autre mode de réalisation avantageux le deuxième trou contact 25* peut être formé avant les deuxièmes trous 25a, 25b. Cela permet de ne pas risquer d'endommager la couche active 150 lors de la réalisation du deuxième trou contact 25*.

Selon un autre mode de réalisation avantageux le deuxième trou contact 25* peut être formé en partie lors de la formation des deuxièmes trous 25a, 25b. Dans ce cas les deuxièmes trous 25a, 25b et deuxième trou contact 25* sont gravés en même temps dans la couche support 20 (et dans la couche de protection 160 si elle est présente) jusqu'à la couche active 150, puis une nouvelle protection est mise en place au-dessus des deuxièmes trous 25a, 25b pour graver la couche active 150 uniquement dans le deuxième trou contact 25*.

Le deuxième trou contact 25* et le premier trou contact 15* se trouvent en vis-à-vis et permettent d'assurer le passage du courant entre les niveaux inférieurs et les niveaux supérieurs du circuit.

On obtient ainsi la deuxième couche support 20 comprenant une pluralité de deuxièmes trous 25a, 25b, et de préférence au moins un deuxième trou contact 25*, qui est formée lors de la quatrième étape du procédé selon l'invention.

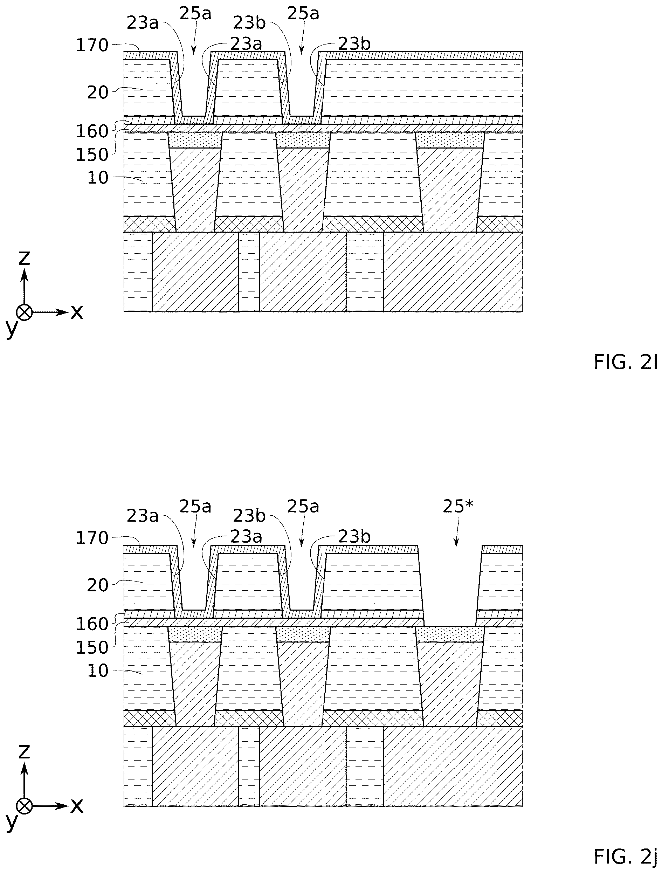

Comme illustré par les figures 2I et 2J, une cinquième étape du procédé consiste en le remplissage de chaque deuxième trou 25a, 25b avec un deuxième via métallique 210a, 210b et une deuxième électrode 220a, 220b.

Les caractéristiques décrites ci-dessous pour un deuxième via métallique 210a, 210b et une deuxième électrode 220a, 220b s'appliquent à l'ensemble des deuxièmes vias métalliques 210a, 210b et des deuxièmes électrodes 220a, 220b.

La deuxième électrode 220a, 220b peut être déposée directement sur la couche active 150, ainsi éventuellement que contre le flanc interne 23a, 23b de la deuxième couche support 20 définissant le trou 20a, 20b dans lequel elle est déposée. Si une deuxième couche active 170 a été déposée sur la couche active 150 et sur le flanc interne 23a, 23b de la deuxième couche support 20, la deuxième électrode 220a, 220b sera déposée la deuxième couche active 170. Dans tous les cas, la deuxième électrode 220a, 220b définit alors une cavité dans laquelle le deuxième via métallique 210a, 210b peut être déposé.

Quelle que soit la forme choisie pour la deuxième électrode 220a, 220b, la deuxième électrode 220a, 220b et le deuxième via métallique 210a, 210b sont en contact.

La deuxième électrode 220a, 220b peut être multicouche. Elle est de préférence monocouche.

La deuxième électrode 220a, 220b est de préférence à base d'un matériau favorisant la création d'un filament conducteur au sein de la couche active 150. Elle peut être à base du même matériau que le deuxième via métallique 210a, 210b, ou bien à base d'un matériau distinct.

L'ensemble constitué du deuxième via métallique 210a, 210b et de la deuxième électrode 220a, 220b se trouvant dans un même deuxième trou 25a, 25b constitue un deuxième ensemble conducteur 200a, 200b. Tout comme les deuxièmes trous 25a, 25b, les deuxièmes ensemble conducteurs 200a, 200b ont un profil continu.

Comme illustré sur la figure 2J, un deuxième via métallique contact 210* et éventuellement une deuxième électrode contact 220* (non représentée) peuvent être formés dans le deuxième trou contact 25*, de préférence lors des mêmes étapes de dépôt et gravure que les deuxièmes vias métalliques 210a, 210b et que les deuxièmes électrodes 220a, 220b, respectivement. Le deuxième via métallique contact 210*, éventuellement avec la deuxième électrode contact 120*, constitue(nt) un deuxième ensemble conducteur contact 200*.

Le dépôt des deuxièmes électrodes 220a, 220b, des deuxièmes vias métalliques 210a, 210b, du deuxième via métallique contact 210* et de la deuxième électrode contact 220* peut par exemple se faire par dépôt physique en phase vapeur (PVD, « Physical Vapor Deposition ») ou encore par dépôt chimique en phase vapeur (CVD, « Chemical Vapor Deposition »).

Comme illustré à la figure 2K, une couche ou ligne 40 peut être formée sur la deuxième couche support 20 et sur les deuxièmes ensembles conducteurs 200a, 200b. Il s'agit typiquement d'une ligne comprenant des éléments de connexion métallique 45a, 45b, du type « fin de ligne » ou « BEOL ». Cette ligne 40 peut être qualifiée de ligne métallique supérieure ou encore de ligne d'interconnexion supérieure.

Chaque deuxième via métallique 210a, 210b est de préférence en contact avec une interconnexion métallique 45a, 45b de la ligne métallique supérieure 40. Par ailleurs, le deuxième ensemble conducteur contact 200* est de préférence en contact avec une interconnexion métallique 45* de la ligne métallique supérieure 40.

Chaque ensemble constitué d'une première électrode 120a, 120b et d'une deuxième électrode 220a, 220b en regard l'une de l'autre, ainsi que de la portion de couche active 150 les séparant, forment un point mémoire 1000a, 1000b.

Par ailleurs, chaque ensemble constitué d'un premier ensemble conducteur contact 100* et d'un deuxième ensemble conducteur contact 200* en regard l'une de l'autre forment un point contact 1000* ou via contact 1000*. Ce via contact 1000* est entièrement conducteur électrique. Il permet ainsi le passage du courant d'un niveau du réseau d'interconnexion au niveau directement supérieur ou inférieur.

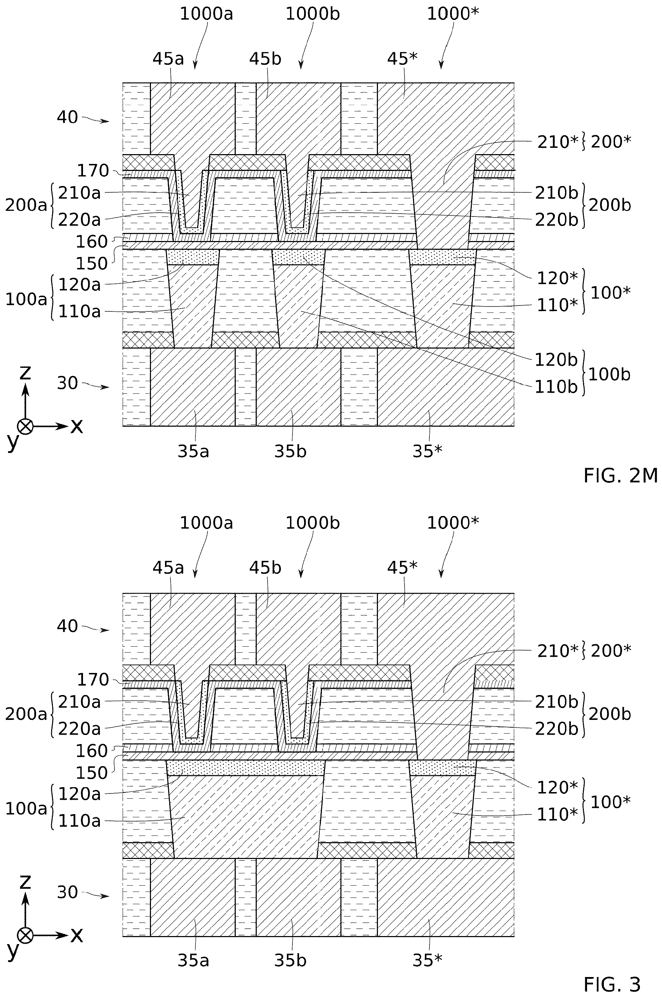

Selon un mode de réalisation illustré à la figure 3, il est possible que plusieurs points mémoires 1000a, 1000b présentent un ensemble conducteur commun, qu'il s'agisse du premier ensemble conducteur 100a ou du deuxième ensemble conducteur 100b. Dit autrement, un même premier via métallique 110a et une même première électrode métallique 120a, ou bien un même deuxième via métallique 210a et une même deuxième électrode métallique 220a peuvent faire partie de plusieurs points mémoires 1000a, 1000b.

Dans l'exemple illustré en figure 3, deux points mémoires 1000a, 1000b ont le même premier ensemble conducteur 100a. Celui-ci s'étend en-dessous de deux ensembles conducteurs 200a, 200b distincts. Pour obtenir un tel dispositif, seul le dimensionnement et le positionnement des premiers trous 15a, 15b est à modifier par rapport à un mode de réalisation dans lequel tous les points mémoires sont constitués de premiers ensembles conducteurs 100a, 100b et de deuxièmes ensembles conducteurs 200a, 200b distincts.

La structure illustrée à la figure 3 correspond à une structure dite 1T2R. Il est entendu qu'il est envisageable de former toute structure du type 1TnR, n étant un entier supérieur à 2, n correspondant au nombre de deuxièmes ensembles conducteurs se trouvant en regard d'un même premier ensemble conducteur.

Le cas 1T1R correspond au mode de réalisation illustré en figure 2M.

Dans le cas d'une structure 1TnR, chaque deuxième via 200a, 200b est de préférence relié à une ligne supérieure (typiquement désignée « bit line ») indépendante permettant d'appliquer une polarisation particulière à chaque point mémoire 1000a, 1000b pendant la lecture ou l'écriture d'un des n points mémoires ainsi formés.

Il est entendu que les dénominations « inférieur » et « supérieur » ne s'entendent pas dans un sens limitatif, notamment quant à l'ordre de réalisation du procédé. Il est tout à fait envisageable que la première couche support 10 soit initialement déposée sur une ligne d'interconnexion qui aura un rôle de ligne métallique supérieure, et que la deuxième couche support 20 soit recouverte d'une ligne d'interconnexion qui aura un rôle de ligne métallique inférieure au sein d'un réseau d'interconnexion de type BEOL.

Il apparaît, au regard des différents modes de réalisation décrits, que grâce à la formation des vias et électrodes au sein des premiers et deuxièmes trous, l'invention permet d'augmenter la densité de points mémoires au sein d'un dispositif. Notamment, il est possible grâce à l'invention d'obtenir des densités plus élevées de points mémoires qu'en les formant par structures de type « mésa ».

Outre les densités de points mémoires plus élevées obtenues grâce à l'invention, on s'affranchit d'un autre défaut des points mémoires à structure « mésa ». En effet, lorsque l'on forme des structures de type « mésa », pour obtenir une densité acceptable de points mémoires, on opte pour des structures présentant une hauteur supérieure à leur diamètre (on parle de facteur de forme élevé, typiquement supérieur à 1:1) ainsi qu'à l'espacement entre structures. Se pose alors le problème d'encapsuler par une couche d'isolant ces matrices de points mémoires sans laisser de trous. Ces trous peuvent en effet créer des problèmes d'intégration, lors de la planarisation par exemple, ou bien encore de fiabilité du dispositif. En intégrant les vias et électrodes dans les trous formés au sein des couches continues 10, 20, on s'affranchit de l'étape d'encapsulation et de planarisation des points mémoires, et il n'existe plus de risque de formation de trous non désirés entre les points mémoires.

L'invention n'est pas limitée aux modes de réalisations précédemment décrits et s'étend à tous les modes de réalisation couverts par l'invention.

## Revendications

1. Dispositif mémoire (1) comprenant une pluralité de points mémoires (1000a, 1000b), le dispositif (1) comprenant une pluralité de premières électrodes (120a, 120b) et une pluralité de deuxièmes électrodes (220a, 220b), chaque deuxième électrode (220a, 220b) se trouvant au moins en partie en regard d'une première électrode (120a, 120b), et en outre une couche active (150) s'étendant de manière continue entre la pluralité de premières électrodes (120a, 120b) et la pluralité de deuxièmes électrodes (220a, 220b), et :
• chaque première électrode (120a, 120b),
• une deuxième électrode (220a, 220b) se trouvant au moins en partie en regard de ladite première électrode (120a, 120b), et
• une portion de couche active (150) s'étendant entre ladite première électrode (120a, 120b) et ladite deuxième électrode (220a, 220b) forment ensemble un point mémoire (1000a, 1000b), le dispositif comprenant un empilement comprenant, empilés selon une direction dite d'empilement (Z), dans cet ordre :
• une première couche support (10) présentant une face supérieure (11), la première couche support (10) comprenant une pluralité de premiers trous (15a, 15b) s'étendant chacun depuis sa face supérieure (11), chaque premier trou (15a, 15b) logeant :
i. un premier via métallique (110a, 110b),
ii. une première électrode (120a, 120b) de la pluralité de premières électrodes (120a, 120b), chaque première électrode (120a, 120b) surmontant un premier via métallique (110a, 110b) distinct,
• la couche active (150), surmontant la face supérieure (11) de la première couche support (10),
• sur la couche active (150), une deuxième couche support (20) comprenant une pluralité de deuxièmes trous (25a, 25b) la traversant et débouchant chacun sur la couche active (150), chaque deuxième trou (25a, 25b) logeant :
i. un deuxième via métallique (210a, 210b),
ii. une deuxième électrode (220a, 220b) de la pluralité de deuxième électrodes (120a, 120b), ladite deuxième électrode (220a, 220b) étant disposée entre le deuxième via métallique (210a, 210b) et la couche active (150), et se trouvant au moins en partie en regard d'une première électrode (120a, 120b) parmi la pluralité de premières électrodes (120a, 120b).

2. Dispositif mémoire (1) selon la revendication précédente dans lequel les premiers trous (15a, 15b) présentent chacun un profil continu le long de la direction d'empilement (Z) en projection dans tout plan comprenant la direction d'empilement (Z).

3. Dispositif mémoire (1) selon l'une quelconque des revendications précédentes dans lequel les deuxièmes trous (25a, 25b) présentent chacun un profil continu le long de la direction d'empilement (Z) en projection dans tout plan comprenant la direction d'empilement (Z).

4. Dispositif mémoire (1) selon l'une quelconque des revendications précédentes dans lequel chaque deuxième électrode (220a, 220b) est en contact direct avec la couche active (150).

5. Dispositif mémoire (1) selon l'une quelconque des revendications précédentes dans lequel au moins une première électrode (120a, 120b) parmi la pluralité de premières électrodes (120a, 120b) se trouve au moins en partie en regard d'au moins deux deuxièmes électrodes (220a, 220b).

6. Dispositif mémoire (1) selon l'une quelconque des revendications 1 à 4, dans lequel chacune des premières électrodes (120a, 120b) se trouve en regard d'une unique deuxième électrode (220a, 220b).

7. Dispositif mémoire (1) selon l'une quelconque des revendications précédentes dans lequel le premier via métallique (110a, 110b) et la première électrode (120a, 120b) contenus dans un même premier trou (15a, 15b) sont à base de matériaux distincts.

8. Dispositif mémoire (1) selon l'une quelconque des revendications précédentes comprenant en outre une couche de protection (160) entre la couche active (150) et la deuxième couche support (20).

9. Dispositif mémoire (1) selon l'une quelconque des revendications précédentes dans lequel chaque première électrode (120a, 120b) affleure la face supérieure (11) de la première couche support (10).

10. Dispositif mémoire (1) selon l'une quelconque des revendications précédentes comprenant en outre une pluralité de premières électrodes secondaires et une pluralité de deuxièmes électrodes secondaires, chaque deuxième électrode secondaire se trouvant au moins en partie en regard d'une première électrode secondaire, le dispositif comprenant en outre une couche active secondaire s'étendant de manière continue entre la pluralité de première électrodes secondaires et la pluralité de deuxièmes électrodes secondaires, et dans lequel :
• chaque première électrode secondaire,
• une deuxième électrode secondaire se trouvant au moins en partie en regard de ladite première électrode secondaire, et
• une portion de couche active secondaire s'étendant entre ladite première électrode secondaire et ladite deuxième électrode secondaire forment ensemble un point mémoire secondaire.

11. Dispositif mémoire (1) selon l'une quelconque des revendications précédentes dans lequel chaque point mémoire (1000a, 1000b) est une mémoire résistive à base d'oxyde (OxRam).

12. Procédé de fabrication d'un dispositif mémoire (1) comprenant une pluralité de points mémoires (1000a, 1000b), le procédé comprenant les étapes suivantes :
• Former une pluralité de premières électrodes (120a, 120b),
• Former une couche active (150) sur chacune des premières électrodes (120a, 120b), la couche active (150) étant continue,
• Former une pluralité de deuxièmes électrodes (220a, 220b) sur la couche active (150), chaque deuxième électrode (220a, 220b) se trouvant au moins en partie en regard d'une première électrode (120a, 120b),
chaque première électrode (120a, 120b), une deuxième électrode (220a, 220b) se trouvant au moins en partie en regard de ladite première électrode (120a, 120b), et une portion de couche active (150) s'étendant entre ladite première électrode (120a, 120b) et ladite deuxième électrode (220a, 220b) formant ensemble un point mémoire (1000a, 1000b), l'étape de formation de la pluralité de premières électrodes (120a, 120b) comprenant les étapes suivantes :
• Fournir une première couche support (10), présentant une face supérieure (11) et une face inférieure (12) opposées l'une à l'autre, la première couche support (10) comprenant une pluralité de premiers trous (15a, 15b) s'étendant chacun depuis sa face supérieure (11) et débouchant sur sa face inférieure (12),
• Former une première électrode (120a, 120b) dans chaque premier trou (15a, 15b) de la pluralité de premiers trous (15a, 15b),
la couche active (150) étant formée sur la face supérieure (11) de la première couche support (10),
le procédé comprenant en outre une étape de formation dans chaque premier trou (15a, 15b) d'un premier via métallique (110a, 110b), la première électrode (120a, 120b) se trouvant au contact du premier via métallique (110a, 110b),
le procédé comprenant en outre comprenant en outre les étapes suivantes :
• Former une deuxième couche support (20) sur la couche active (150), la deuxième couche support (20) comprenant une pluralité de deuxièmes trous (25a, 25b) traversant la deuxième couche support (20) et débouchant chacun sur la couche active (150), chaque deuxième trou (25a, 25b) se trouvant au moins en partie en regard d'une première électrode (220a, 220b) différente,
• Former dans chaque deuxième trou (25a, 25b) de la pluralité de deuxièmes trous (25a, 25b) une deuxième électrode (220a, 220b) de la pluralité de deuxièmes électrodes (220a, 200b) et un deuxième via métallique (210a, 210b), la deuxième électrode (220a, 220b) se trouvant au contact du deuxième via métallique (210a, 210b).

13. Procédé selon la revendication précédente dans lequel la formation de la deuxième couche support (20) comprend une étape de dépôt de la couche support (20) et une étape de formation dans la couche support (20) de la pluralité de premiers trous (15a, 15b), le procédé comprenant en outre, avant la formation dans chaque deuxième trou (25a, 25b) du deuxième via métallique (210a, 210b) et de la deuxième électrode (220a, 220b), une étape de traitement de la couche active (150), l'étape de traitement de la couche active (150) ayant de préférence lieu à l'un parmi les temps suivants:
• Avant la formation de la deuxième couche support (20),
• Après le dépôt de la deuxième couche support (20) et avant la formation de la pluralité de premiers trous (15a, 15b),
• Après la formation de la pluralité de premiers trous (15a, 15b).

## Patentansprüche

1. Speichervorrichtung (1), die eine Vielzahl von Speicherpunkten (1000a, 1000b) umfasst, wobei die Vorrichtung (1) eine Vielzahl erster Elektroden (120a, 120b) und eine Vielzahl zweiter Elektroden (220a, 220b) umfasst, wobei sich jede zweite Elektrode (220a, 220b) mindestens zum Teil gegenüber einer ersten Elektrode (120a, 120b) befindet, und außerdem eine aktive Schicht (150), die sich durchgehend zwischen der Vielzahl erster Elektroden (120a, 120b) und der Vielzahl zweiter Elektroden (220a, 220b) erstreckt, und dass:
• jede erste Elektrode (120a, 120b),
• eine zweite Elektrode (220a, 220b), die sich mindestens zum Teil gegenüber der ersten Elektrode (120a, 120b) befindet, und
• ein Abschnitt aktiver Schicht (150), der sich zwischen der ersten Elektrode (120a, 120b) und der zweiten Elektrode (220a, 220b) erstreckt, gemeinsam einen Speicherpunkt (1000a, 1000b) bilden,
wobei die Vorrichtung eine Stapelung umfasst, die gemäß einer Stapelungsrichtung genannten Richtung (Z) in der folgenden Reihenfolge Folgendes umfasst:
• eine erste Tragschicht (10), die eine obere Fläche (11) aufweist, wobei die erste Tragschicht (10) eine Vielzahl erster Löcher (15a, 15b) umfasst, die sich jeweils von ihrer oberen Schicht (11) erstrecken, wobei jedes Loch (15a, 15b) Folgendes aufnimmt:
i. ein erstes metallisches Via (110a, 110b),
ii. eine erste Elektrode (120a, 120b) der Vielzahl erster Elektroden (120a, 120b), wobei sich jede erste Elektrode (120a, 120b) über einem ersten getrennten metallischen Via (110a, 110b) befindet,
• sich die aktive Schicht (150) über der oberen Fläche (11) der ersten Tragschicht (10) befindet,
• auf der aktiven Schicht (150) eine zweite Tragschicht (20), die eine Vielzahl zweiter Löcher (25a, 25b) umfasst, die sie durchqueren und jeweils auf der aktiven Schicht (150) münden, wobei jedes zweite Loch (25a, 25b) Folgendes aufnimmt:
i. ein zweites metallisches Via (210a, 210b),
ii. eine zweite Elektrode (220a, 220b) der Vielzahl zweiter Elektroden (120a, 120b), wobei die zweite Elektrode (220a, 220b) zwischen dem zweiten metallischen Via (210a, 210b) und der aktiven Schicht (150) angeordnet ist und sich mindestens zum Teil gegenüber einer ersten Elektrode (120a, 120b) der Vielzahl erster Elektroden (120a, 120b) befindet.

2. Speichervorrichtung (1) nach dem vorstehenden Anspruch, wobei die ersten Löcher (15a, 15b) jeweils ein durchgehendes Profil entlang der Stapelungsrichtung (Z) in der Projektion in jede Ebene aufweisen, die die Stapelrichtung (Z) umfasst.

3. Speichervorrichtung (1) nach einem der vorstehenden Ansprüche, wobei die zweiten Löcher (25a, 25b) jeweils ein durchgehendes Profil entlang der Stapelungsrichtung (Z) in der Projektion in jede Ebene aufweisen, die die Stapelungsrichtung (Z) umfasst.

4. Speichervorrichtung (1) nach einem der vorstehenden Ansprüche, wobei jede zweite Elektrode (220a, 220b) mit der aktiven Schicht (150) in direktem Kontakt steht.

5. Speichervorrichtung (1) nach einem der vorstehenden Ansprüche, wobei sich mindestens eine erste Elektrode (120a, 120b) der Vielzahl erster Elektroden (120a, 120b) mindestens zum Teil gegenüber von mindestens zwei zweiten Elektroden (220a, 220b) befindet.

6. Speichervorrichtung (1) nach einem der Ansprüche 1 bis 4, wobei sich jede der ersten Elektroden (120a, 120b) gegenüber einer einzigen zweiten Elektrode (220a, 220b) befindet.

7. Speichervorrichtung (1) nach einem der vorstehenden Ansprüche, wobei das erste metallische Via (110a, 110b) und die erste Elektrode (120a, 120b), die in demselben ersten Loch (15a, 15b) enthalten sind, auf unterschiedlichen Materialien basieren.

8. Speichervorrichtung (1) nach einem der vorstehenden Ansprüche, die außerdem eine Schutzschicht (160) zwischen der aktiven Schicht (150) und der zweiten Tragschicht (20) umfasst.

9. Speichervorrichtung (1) nach einem der vorstehenden Ansprüche, wobei jede erste Elektrode (120a, 120b) mit der oberen Fläche (11) der ersten Tragschicht (10) bündig ist.

10. Speichervorrichtung (1) nach einem der vorstehenden Ansprüche, die außerdem eine Vielzahl erster Sekundärelektroden und eine Vielzahl zweiter Sekundärelektroden umfasst, wobei sich jede zweite Sekundärelektrode mindestens zum Teil gegenüber einer ersten Sekundärelektrode befindet, wobei die Vorrichtung außerdem eine aktive Sekundärschicht umfasst, die sich durchgehend zwischen der Vielzahl erster Sekundärelektroden und der Vielzahl zweiter Sekundärelektroden erstreckt und wobei:
• jede erste Sekundärelektrode,
• eine zweite Sekundärelektrode, die sich mindestens zum Teil gegenüber der ersten Sekundärelektrode befindet, und
• ein Abschnitt aktiver Sekundärschicht, der sich zwischen der ersten Sekundärelektrode und der zweiten Sekundärelektrode erstreckt, gemeinsam einen Sekundärspeicherpunkt bilden.

11. Speichervorrichtung (1) nach einem der vorstehenden Ansprüche, wobei jeder Speicherpunkt (1000a, 1000b) ein resistiver Speicher auf Oxidbasis (OxRam) ist.

12. Herstellungsverfahren einer Speichervorrichtung (1), die eine Vielzahl von Speicherpunkten (1000a, 1000b) umfasst, wobei das Verfahren die folgenden Schritte umfasst:
• Bilden einer Vielzahl erster Elektroden (120a, 120b),
• Bilden einer aktiven Schicht (150) auf jeder der ersten Elektroden (120a, 120b), wobei die aktive Schicht (150) durchgehend ist,
• Bilden einer Vielzahl zweiter Elektroden (220a, 220b) auf der aktiven Schicht (150), wobei sich jede zweite Elektrode (220a, 220b) mindestens zum Teil gegenüber einer ersten Elektrode (120a, 120b) befindet,
wobei sich jede erste Elektrode (120a, 120b), eine zweite Elektrode (220a, 220b), die sich mindestens zum Teil gegenüber der ersten Elektrode (120a, 120b) befindet, und ein Abschnitt der aktiven Schicht (150) zwischen der ersten Elektrode (120a, 120b) und der zweiten Elektrode (220a, 220b) erstrecken und gemeinsam einen Speicherpunkt (1000a, 1000b) bilden, wobei der Schritt des Bildens der Vielzahl erster Elektroden (120a, 120b) die folgenden Schritte umfasst:
• Bereitstellen einer ersten Tragschicht (10), die eine obere Fläche (11) und eine untere Fläche (12), die einander entgegengesetzt sind, aufweist, wobei die erste Tragschicht (10) eine Vielzahl erster Löcher (15a, 15b) umfasst, die sich jeweils von ihrer oberen Fläche (11) erstrecken und auf ihrer unteren Fläche (12) münden,
• Bilden einer ersten Elektrode (120a, 120b) in jedem ersten Loch (15a, 15b) der Vielzahl erster Löcher (15a, 15b),
wobei die aktive Schicht (150) auf der oberen Fläche (11) der ersten Tragschicht (10) gebildet ist,
wobei das Verfahren außerdem einen Schritt des Bildens in jedem ersten Loch (15a, 15b) eines ersten metallischen Vias (110a, 110b) umfasst, wobei die erste Elektrode (120a, 120b) mit dem ersten metallischen Via (110a, 110b) in Kontakt steht, wobei das Verfahren außerdem die folgenden Schritte umfasst:
• Bilden einer zweiten Tragschicht (20) auf der aktiven Schicht (150), wobei die zweite Tragschicht (20) eine Vielzahl zweiter Löcher (25a, 25b) umfasst, die die zweite Tragschicht (20) durchqueren und jeweils auf der aktiven Schicht (150) münden, wobei sich jedes zweite Loch (25a, 25b) mindestens zum Teil gegenüber einer ersten unterschiedlichen Elektrode 220a, 220b) erstreckt,
• Bilden in jedem zweiten Loch (25a, 25b) der Vielzahl zweiter Löcher (25a, 25b) einer zweiten Elektrode (220a, 220b) der Vielzahl zweiter Elektroden (220a, 200b) und eines zweiten metallischen Vias (210a, 210b), wobei sich die zweite Elektrode (220a, 220b) mit dem zweiten metallischen Via (210a, 210b) in Kontakt befindet.

13. Verfahren nach dem vorstehenden Anspruch, wobei das Bilden der zweiten Tragschicht (20) einen Schritt des Abscheidens der Tragschicht (20) und einen Schritt des Bildens in der Tragschicht (20) der Vielzahl erster Löcher (15a, 15b) umfasst, wobei das Verfahren außerdem vor dem Bilden in jedem zweiten Loch (25a, 25) des zweiten metallischen Vias (210a, 210b) und der zweiten Elektrode (220a, 220b) einen Behandlungsschritt der aktiven Schicht (150) umfasst, wobei der Behandlungsschritt der aktiven Schicht (150) bevorzugt zu einem der folgenden Zeitpunkte stattfindet:
• vor dem Bilden der zweiten Tragschicht (20),
• nach dem Abscheiden der zweiten Tragschicht (20) und vor dem Bilden der Vielzahl erster Löcher (15a, 15b),
• nach dem Bilden der Vielzahl erster Löcher (15a, 15b).

## Claims

1. Memory device (1) comprising a plurality of memory points (1000a, 1000b), the device (1) comprising a plurality of first electrodes (120a, 120b) and a plurality of second electrodes (220a, 220b), each second electrode (220a, 220b) being located at least partially facing a first electrode (120a, 120b), further an active layer (150) extending continuously between the plurality of first electrodes (120a, 120b) and the plurality of second electrodes (220a, 220b), and:
• each first electrode (120a, 120b),
• a second electrode (220a, 220b) being located at least partially facing said first electrode (120a, 120b), and
• an active layer (150) portion extending between said first electrode (120a, 120b) and said second electrode (220a, 220b)
together form a memory point (1000a, 1000b),
the device comprising a stack comprising, stacked along a so-called stacking direction (Z), in this order:
• a first support layer (10) having an upper face (11), the first support layer (10) comprising a plurality of first holes (15a, 15b) each extending from its upper face (11), each first hole (15a, 15b) housing:
i. a first metal via (110a, 110b),
ii. a first electrode (120a, 120b) of the plurality of first electrodes (120a, 120b), each first electrode (120a, 120b) surmounting a distinct first metal via (110a, 110b),
• the active layer (150), surmounting the upper face (11) of the first support layer (10),
• on the active layer (150), a second support layer (20) comprising a plurality of second holes (25a, 25b) passing through it and each opening onto the active layer (150), each second hole (25a, 25b) housing:
i. a second metal via (210a, 210b),
ii. a second electrode (220a, 220b) of the plurality of second electrodes (120a, 120b), said second electrode (220a, 220b) being disposed between the second metal via (210a, 210b) and the active layer (150), and being located at least partially facing a first electrode (120a, 120b) from among the plurality of first electrodes (120a, 120b).

2. Memory device (1) according to the preceding claim, wherein the first holes (15a, 15b) each have a continuous profile along the stacking direction (Z) projecting into any plane comprising the stacking direction (Z).

3. Memory device (1) according to any one of the preceding claims, wherein the second holes (25a, 25b) each have a continuous profile along the stacking direction (Z) projecting into any plane comprising the stacking direction (Z).

4. Memory device (1) according to any one of the preceding claims, wherein each second electrode (220a, 220b) is in direct contact with the active layer (150).

5. Memory device (1) according to any one of the preceding claims, wherein at least one first electrode (120a, 120b) from among the plurality of first electrodes (120a, 120b) is located at least partially facing at least two second electrodes (220a, 220b).

6. Memory device (1) according to any one of claims 1 to 4, wherein each of the first electrodes (120a, 120b) is located facing one single second electrode (220a, 220b).

7. Memory device (1) according to any one of the preceding claims, wherein the first metal via (110a, 110b) and the first electrode (120a, 120b) contained in one same first hole (15a, 15b) are with the basis of distinct materials.

8. Memory device (1) according to any one of the preceding claims, further comprising a protective layer (160) between the active layer (150) and the second support layer (20).

9. Memory device (1) according to any one of the preceding claims, wherein each first electrode (120a, 120b) is flush with the upper face (11) of the first support layer (10).

10. Memory device (1) according to any one of the preceding claims, further comprising a plurality of first secondary electrodes and a plurality of second secondary electrodes, each second secondary electrode being located at least partially facing a first secondary electrode, the device further comprising a secondary active layer extending continuously between the plurality of first secondary electrodes and the plurality of second secondary electrodes, and in which:
• each first secondary electrode,
• a second secondary electrode being located at least partially facing said first secondary electrode, and
• a secondary active layer portion extending between said first secondary electrode and said second secondary electrode
together form a secondary memory point.

11. Memory device (1) according to any one of the preceding claims, wherein each memory point (1000a, 1000b) is an oxide-based resistive memory (OxRam).

12. Method for manufacturing a memory device (1) comprising a plurality of memory points (1000a, 1000b), the method comprising the following steps:
• Forming a plurality of first electrodes (120a, 120b),
• Forming an active layer (150) on each of the first electrodes (120a, 120b), the active layer (150) being continuous,
• Forming a plurality of second electrodes (220a, 220b) on the active layer (150), each second electrode (220a, 220b) being located at least partially facing a first electrode (120a, 120b),
each first electrode (120a, 120b), a second electrode (220a, 220b) being located at least partially facing said first electrode (120a, 120b), and an active layer (150) portion extending between said first electrode (120a, 120b) and said second electrode (220a, 220b) together forming a memory point (1000a, 1000b),
the step of forming the plurality of first electrodes (120a, 120b) comprising the following steps:
• Providing a first support layer (10), having an upper face (11) and a lower face (12) opposite one another, the first support layer (10) comprising a plurality of first holes (15a, 15b), each extending from its upper face (11) and opening onto its lower face (12),
• Forming a first electrode (120a, 120b) in each first hole (15a, 15b) of the plurality of first holes (15a, 15b),
the active layer (150) being formed on the upper face (11) of the first support layer (10), the method further comprising a formation step in each first hole (15a, 15b) of a first metal via (110a, 110b), the first electrode (120a, 120b) being located in contact with the first metal via (110a, 110b),
the method further comprising the following steps:
• Forming a second support layer (20) on the active layer (150), the second support layer (20) comprising a plurality of second holes (25a, 25b) passing through the second support layer (20) and each opening onto the active layer (150), each second hole (25a, 25b) being located at least partially facing a different first electrode (220a, 220b),
• Forming, in each second hole (25a, 25b) of the plurality of second holes (25a, 25b), a second electrode (220a, 220b) of the plurality of second electrodes (220a, 200b) and a second metal via (210a, 210b), the second electrode (220a, 220b) being located in contact with the second metal via (210a, 210b).

13. Method according to the preceding claim, wherein the formation of the second support layer (20) comprises a step of depositing the support layer (20) and a formation step of the plurality of first holes (15a, 15b) in the support layer (20), the method further comprising, before the formation in each second hole (25a, 25b) of the second metal via (210a, 210b) and of the second electrode (220a, 220b), a step of treating the active layer (150), the step of treating the active layer (150) preferably taking place at one from among the following times:
• Before the formation of the second support layer (20),
• After the deposition of the second support layer (20) and before the formation of the plurality of first holes (15a, 15b),
• After the formation of the plurality of first holes (15a, 15b).
